(19) Europäisches Patentamt
European Patent Office
Office européen des brevets

(11) **EP 2 843 427 B1**

(12) **EUROPÄISCHE PATENTSCHRIFT**

(45) Veröffentlichungstag und Bekanntmachung des Hinweises auf die Patenterteilung:
**03.10.2018 Patentblatt 2018/40**

(51) Int Cl.:
*G01R 19/02* (2006.01)    *G01R 19/25* (2006.01)
*G01R 29/16* (2006.01)

(21) Anmeldenummer: **13182677.8**

(22) Anmeldetag: **02.09.2013**

(54) **Ermittlung elektrischer Größen in Polygon- und Sternschaltungen**

Determining electrical values in polygonal and star circuits

Détermination de grandeurs électriques dans des circuits polygonaux et en étoile

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**04.03.2015 Patentblatt 2015/10**

(73) Patentinhaber: **Advanced Energy Industries Gmbh**
**72555 Metzingen (DE)**

(72) Erfinder:
• **Schaffarra, Christian**
**59602 Rüthen (DE)**
• **Jury, Reinhard**
**59929 Brilon (DE)**
• **Fikri, Hassan**
**59581 Warstein (DE)**

(74) Vertreter: **Graefe, Jörg et al**
**Fritz Patent- und Rechtsanwälte**
**Partnerschaft mbB**
**Postfach 1580**
**59705 Arnsberg (DE)**

(56) Entgegenhaltungen:
EP-A1- 2 549 280        WO-A1-03/031996
WO-A1-2013/106763    JP-A- 2012 173 110
US-A1- 2012 259 565

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren zur Ermittlung elektrischer Größen in einer Polygonschaltung oder einer Sternschaltung ohne Neutralleiter eines Mehrphasenwechselstromsystems mit $P$ Phasen, wobei die Polygonschaltung bzw. die Sternschaltung aus vorzugsweise ohmschen Lasten aufgebaut ist und wobei mittels einer Messeinrichtung durch synchrone Abtastung

- von verketteten Spannungen $u_{p,p+1}(t)$ und $u_{P,1}(t)$ und
- von Außenleiterströmen $i_p(t)$,

zum Erhalt von Augenblickswerten $\underline{u}_{p,p+1}$ und $\underline{u}_{P,1}$ der verketteten Spannungen und Augenblickswerten $\underline{i}_p$ der Außenleiterströme gemessen werden, wobei $3 \leq P$, $1 \leq p \leq P$ und $p$ eine natürliche Zahl, insbesondere mit $P = 3$, ist.

Synchrone Abtastung im Sinne der Anmeldung bedeutet, dass die verketteten Spannungen $u_{p,p+1}(t)$ und $\underline{u}_{P,1}(t)$ und die Außenleiterströme $i_p(t)$ gleichzeitig abgetastet werden.

Aus dem Stand der Technik sind verschiedenen Verfahren zur Messung elektrischer Größen im Dreiphasenwechselstromsystem in Sternschaltungen und Dreieckschaltungen bekannt. Es sind auch einige Verfahren zur Messung elektrischer Größen in Sternschaltungen und Dreiecksschaltungen bekannt, die keinen Neutralleiter haben und bei denen ohmsche Lasten der Sternschaltungen bzw. Dreiecksschaltungen nicht zugänglich sind, so dass unmittelbar an den Lasten keine Messungen vorgenommen werden können. Eine Schaltung, mit der ein bekanntes Messverfahren durchgeführt werden kann, ist eine Aron-Schaltung.

Die Aronschaltung ist zur Ermittlung von Wirk- und Blindleistungen geeignet, das heißt, dass auch Leistungen in Schaltungen mit kapazitiven oder induktiven Lasten ermittelt werden können. Eine Aronschaltung hat den Nachteil, dass sie nur bei sinusförmigen Spannungen verwendet werden kann. Wird in den Schaltungen zur Einstellung der Leistung der Lasten ein Phasenanschnitt oder ein Phasenabschnitt genutzt, ist eine Leistungsmessung mit der Aronschaltung nicht möglich. Ein weiterer Nachteil ist, dass mit der Aronschaltung nur bei symmetrischer Belastung die Leistungen der einzelnen Lasten bestimmt werden können.

Ein Verfahren zur Messung einer Leistung mittels einer Aronschaltung ist in dem Dokument US 2012/0259565 A1 beschrieben. Das Dokument offenbart eine besondere Schaltung, mit der Messungen berührungslos durchgeführt werden können. Um die Messungen durchführen zu können, wird ein aktiver Sensoraufbau benötigt. Weder das in dem Dokument offenbarte Verfahren noch die in dem Dokument offenbarte Vorrichtung ändert etwas an den vorgenannten Nachteilen der Aronschaltung.

Der Erfindung liegt daher die Aufgabe zugrunde, insbesondere für den Fall ohmscher Lasten ein Verfahren vorzuschlagen, welches eine Messung der Leistungen der einzelnen Lasten bei symmetrischer oder unsymmetrischer Belastung erlaubt und auch für nicht sinusförmige Spannungen, insbesondere bei Phasenanschnitt verwendet werden kann. Außerdem sollen auch andere elektrische Größen der Schaltungen bestimmt werden können, als die Leistung.

Diese Aufgabe wird erfindungsgemäß dadurch gelöst, dass für die Polygonschaltung die Effektivwerte der Lastströme $I_{1,2},...,I_{P-1,P},I_{P,1}$ bzw. die Sternschaltung die Effektivwerte der Lastspannungen $U_{1,N},...,U_{P,N}$ mit Hilfe von Produkten

$$\underline{h}_p = \underline{u}_{p,p+1} \cdot \underline{i}_p \, , \; \ldots \, , \; \underline{h}_{P-1} = \underline{u}_{P-1,P} \cdot \underline{i}_{P-1} \, , \; \underline{h}_P = \underline{u}_{P,1} \cdot \underline{i}_P \qquad (1)$$

der Augenblickswerte der verkettete Spannungen $\underline{u}_{p,p+1}$ und $\underline{u}_{P,1}$ und der Augenblickswerte $\underline{i}_p$ der Außenleiterströme berechnet werden.

Die Produkte gemäß den Gleichungen 1 werden nachfolgend als Augenblickswerte $\underline{h}_p$ einer Hilfsgröße bezeichnet.

Die Augenblickswerte $\underline{h}_p$ der Hilfsgrößen haben die Einheit einer Leistung. Die Hilfsgrößen sind keine realen Größen. Es gibt keine Last, in welcher eine Leistung entsprechend einer der Hilfsgrößen umgesetzt wird. Die Hilfsgrößen sind lediglich Größen, die zum weiteren Berechnen der gesuchten elektrischen Größen, wie zum Beispiel der Effektivwerte $I_{1,2},...,I_{P-1,P},I_{P,1}$ der Lastströme in der Polygonschaltung bzw. der Effektivwerte $U_{1,N},...,U_{P,N}$ der Lastspannungen in der Sternschaltung benutzt werden.

Für das Berechnen der gesuchten Größen ist es hilfreich, die aus den Augenblickswerten $\underline{u}_{p,p+1}$ und $\underline{u}_{P,1}$ der verketteten Spannungen quadratische Mittelwerte (Effektivwerte) $U_{p,p+1}$ und $U_{P,1}$ der verketteten Spannung zu berechnen. Ebenso ist es sinnvoll, die aus den Augenblickswerten $\underline{i}_p$ der Außenleiterströme quadratische Mittelwerte (Effektivwerte) $I_p$ der Außenleiterströme zu berechnen.

Die näherungsweise Berechnung von Effektivwerten X einer aus Augenblickswerten x ist allgemein nach folgender Gleichung möglich:

$$X \approx \sqrt{\frac{1}{T}\sum_{i=1}^{N}{x_i}^2 \cdot \Delta t_i} \qquad (2)$$

wobei $T$ die Periode ist, über welche die Abtastung der zeitkontinuierlichen Größe $x(t)$ erfolgt ist und $\Delta t_i$ zeitlichen Abstände der Abtastmoment sind.

Bei äquidistanter Abtastung vereinfacht sich die Gleichung (3) zu

$$X \approx \sqrt{\frac{1}{N}\sum_{i=1}^{N}{x_i}^2} \qquad (4)$$

Ebenso lassen sich aus den Augenblickswerten $h_p$ der Hilfsgrößen Effektivwerte $H_p$ der Hilfsgrößen berechnen. Die Berechung kann bei äquidistanter Abtastung unmittelbar aus den Augenblickswerten $u_{p,p+1}$ und $u_{P,1}$ der verketteten Spannungen und den Augenblickswerten $i_p$ Außenleiterströme gemäß der nachfolgenden Gleichung erfolgen:

$$H_1 = \frac{\sum_{n=1}^{N}\underline{u}_{1,21}(n) \cdot \underline{i}_1(n)}{N}, \ldots, H_{P-1} = \frac{\sum_{n=1}^{N}\underline{u}_{P-1,P}(n) \cdot \underline{i}_{P-1}(n)}{N}, H_P = \frac{\sum_{n=1}^{N}\underline{u}_{P,1}(n) \cdot \underline{i}_P(n)}{N}$$

$$(5)$$

wobei $n$ die Abtastzeitpunkte zur Messung der Augenblickswerte $u_{p,p+1}$ und $u_{P,1}$ der verketteten Spannungen und der Augenblickswerte $i_p$ der Außenleiterströme bezeichnet. $N$ ist die Anzahl der Abtastungen.

Aus den Effektivwerten $H_p$ der Hilfsgrößen, den Effektivwerten $U_{p,p+1}$ und $U_{P,1}$ der verketteten Spannung und den Effektivwerten $I_p$ der Außenleiterströme können Phasenverschiebungswinkel $\alpha_p$ zwischen den verketteten Spannungen $u_{p,p+1}(t)$ und $u_{P,1}(t)$ und den Außenleiterströmen $i_p$ berechnet werden. Die Berechung kann gemäß folgender Gleichungen erfolgen:

$$\alpha_p = \cos^{-1}\frac{H_p}{I_p \cdot U_{p,p+1}} \text{ für } 1 \le p < P \text{ bzw.} \qquad (6)$$

$$\alpha_P = \cos^{-1}\frac{H_P}{I_P \cdot U_{P,1}} \text{ für } p = P. \qquad (7)$$

Die Berechung nach den Gleichungen (6) und (7) macht sich die Erkenntnis zu nutze, dass die Effektivwerte $H_p$ der Hilfsgrößen, den Skalarprodukten

$$H_p = I_p \cdot U_{p,p+1} \cdot \cos\alpha_p \qquad (8)$$

der Effektivwerte $U_{p,p+1}$ und $U_{P,1}$ der verketteten Spannungen und der Effektivwerte $I_p$ der Außenleiterströme entspricht.

Soweit sind die Überlegungen sowohl für Polygonschaltungen als auch für Sternschaltungen in Mehrphasenwechselstromsystemen allgemein gültig.

Nähere Betrachtungen werden nun für Sternschaltungen und Dreiecksschaltungen in Dreiphasenwechselstromsystemen angestellt. Für ein einfacheres Verständnis wird dazu auf die Figuren verwiesen.

Es zeigt

Fig. 1     eine Dreiecksschaltung mit drei Lasten,

Fig. 2     ein Zeigerdiagramm zur Schaltung gemäß Fig. 1

Fig. 3    ein Zeigerdiagramm zur Schaltung gemäß Fig. 1 bei unsymmetrischer Belastung durch drei ungleiche Lasten.

Fig. 4    eine Sternschaltung mit drei Lasten,

Fig. 5    ein Zeigerdiagramm zur Schaltung gemäß Fig. 4 bei symmetrischer Belastung durch drei gleiche Lasten und

Fig. 6    ein Zeigerdiagramm zur Schaltung gemäß Fig. 4 bei unsymmetrischer Belastung durch drei ungleiche Lasten.

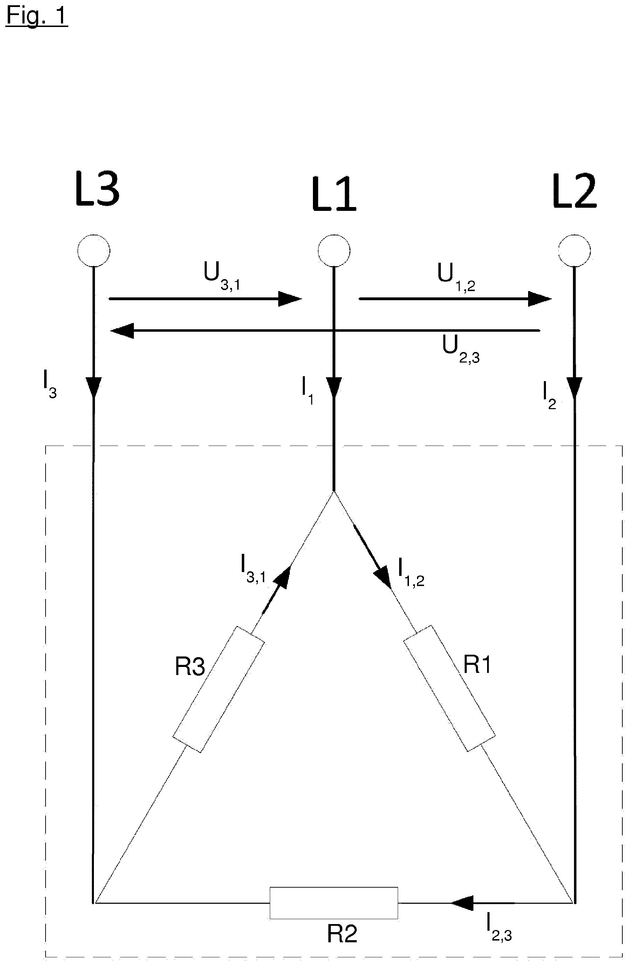

Die Dreieckschaltung gemäß Fig. 1 hat Lasten R1, R2, R3, die im Dreieck geschaltet sind. Die Lasten R1, R2, R3 werden über drei Außenleiter L1, L2, L3 einer Dreiphasenwechselstromversorgung mit elektrischer Energie versorgt. In den Außenleitern L1, L2, L3 fließen durch eine Messeinrichtung (nicht dargestellt) erfasst Außenleiterströme mit Effektivwerten $I_1$, $I_2$, $I_3$. Zwischen den Außenleitern L1, L2, L3 liegen verkettete Spannungen mit Effektivwerten $U_{1,2}$, $U_{2,3}$, $U_{3,1}$ an, die auch über die Lasten R1, R2, R3 abfallen. Auch die verketteten Spannungen können durch die Messeinrichtung erfasst werden. Die Effektivwerte $I_1$, $I_2$, $I_3$ der Außenleiterströme und die Effektivwerte $U_{1,2}$, $U_{2,3}$, $U_{3,1}$ der verketteten Spannungen können gemäß Gleichung (2) oder (3) aus gemessenen Augenblickswerten berechnet werden.

Durch die Lasten R1, R2, R3 fließen Lastströme $I_{1,2}$, $I_{2,3}$, $I_{3,1}$, die nicht gemessen werden, die aber durch die Erfindung berechnet werden können. Ebenso wenig werden die Leistungen der Lasten R1, R2, R3 gemessen. Die Leistungen können aber berechnet werden, wenn die Lastströme $I_{1,2}$, $I_{2,3}$, $I_{3,1}$ durch Berechnung bekannt sind. Sind die Leistungen der Lasten R1, R2, R3 bekannt, kann die Gesamtleistung aller Lasten R1, R2, R3 berechnet werden.

Es wird nun davon ausgegangen, dass durch Messung und Berechnung die Effektivwerte $I_1$, $I_2$, $I_3$ der Außenleiterströme und die Effektivwerte $U_{1,2}$, $U_{2,3}$, $U_{3,1}$ der verkettete Spannungen bekannt sind.

Ferner wurden mittels der Effektivwerte $H_p$ der Hilfsgrößen die Phasenverschiebungswinkel $\alpha_p$ zwischen den verketteten Spannungen $u_{p,p+1}$ und den Außenleiterströmen $i_p$ berechnet (Gleichungen (5) und (6)).

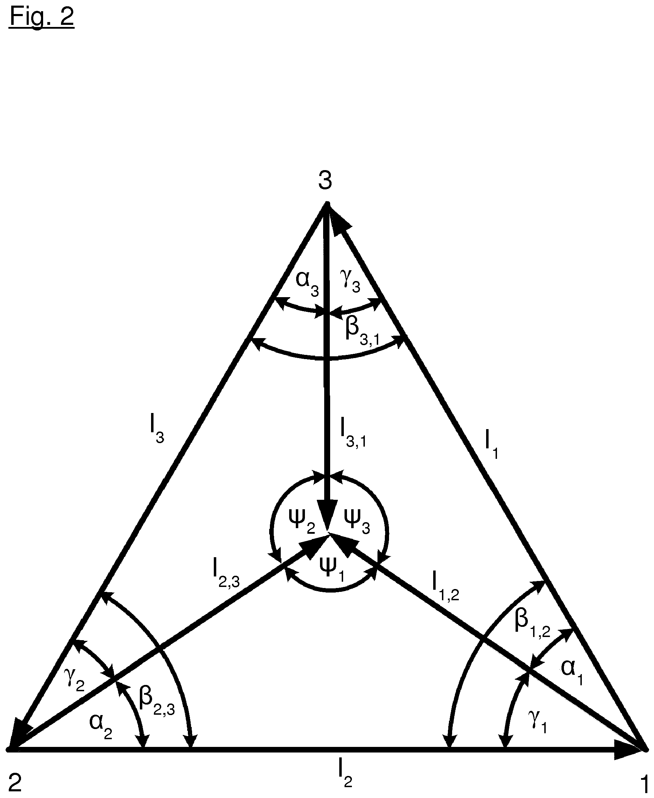

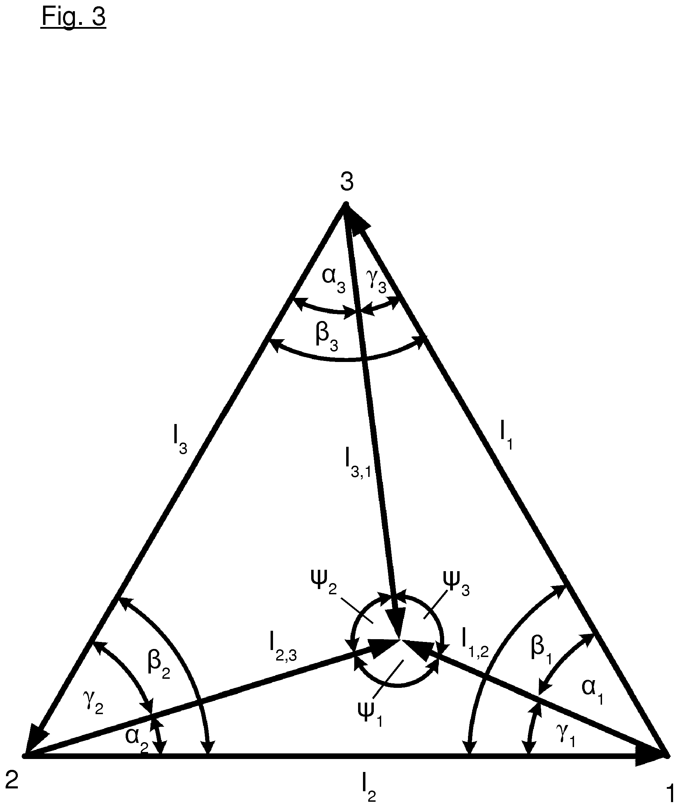

Betrachtet man nun die Zeigerdiagramme aus Fig. 2 und 3 und wendet den Kosinussatz auf das durch die Zeiger der Außenleiterströme aufgespannte Dreieck an, ergibt sich:

$$I_3{}^2 = I_1{}^2 + I_2{}^2 - 2 \cdot I_1 \cdot I_2 \cdot \cos \beta_{1,2} \,, \qquad (8)$$

$$I_1{}^2 = I_2{}^2 + I_3{}^2 - 2 \cdot I_2 \cdot I_3 \cdot \cos \beta_{2,3} \,, \qquad (9)$$

$$I_2{}^2 = I_1{}^2 + I_3{}^2 - 2 \cdot I_1 \cdot I_3 \cdot \cos \beta_{3,1} \,, \qquad (10)$$

wobei $\beta_{1,2}$, $\beta_{2,3}$, $\beta_{3,1}$ Phasenverschiebungswinkel zwischen zwei Außenleiterströmen $i_1$, $i_2$, $i_3$ bezeichnen.

Löst man diese Gleichungen nach den Phasenverschiebungswinkeln $\beta_{1,2}$, $\beta_{2,3}$, $\beta_{3,1}$ auf, ergibt sich:

$$\beta_{1,2} = \cos^{-1} \frac{I_1{}^2 + I_2{}^2 - I_3{}^2}{2 \cdot I_1 \cdot I_2} \,, \qquad (11)$$

$$\beta_{2,3} = \cos^{-1} \frac{I_2{}^2 + I_3{}^2 - I_1{}^2}{2 \cdot I_2 \cdot I_3} \text{ und} \qquad (12)$$

$$\beta_{3,1} = \cos^{-1} \frac{I_3{}^2 + I_1{}^2 - I_2{}^2}{2 \cdot I_3 \cdot I_1} \,. \qquad (13)$$

Sind die Phasenverschiebungswinkel $\alpha_1$, $\alpha_2$, $\alpha_3$ zwischen den verketteten Spannungen $u_{1,2}$, $u_{2,3}$, $u_{3,1}$ und den Außenleiterströmen $i_p$ (siehe Gleichungen (5) und (6)) und die Phasenverschiebungswinkel $\beta_{1,2}$, $\beta_{2,3}$, $\beta_{3,1}$ bekannt, können die Phasenverschiebungswinkel $\gamma_1$, $\gamma_2$, $\gamma_3$ zwischen den verketteten Spannungen $u_{1,2}$, $u_{2,3}$, $u_{3,1}$ und den Außenleiterströmen $i_1$, $i_2$, $i_3$ berechnet werden. Das ist einfach möglich, wenn die Lasten R1, R2, R3 beliebige ohmsche Lasten sind und die Lastströme $i_{1,2}$, $i_{2,3}$, $i_{3,1}$ deshalb in Phase mit den verketteten Spannungen $u_{1,2}$, $u_{2,3}$, $u_{3,1}$, d.h. den Lastspannungen sind. Dies vorausgesetzt ergeben sich die Phasenverschiebungswinkel $\gamma_1$, $\gamma_2$, $\gamma_3$ zwischen den verketteten Spannungen $u_{1,2}$, $u_{2,3}$, $u_{3,1}$ und den Außenleiterströmen $i_2$, $i_3$, $i_1$ zu

$$\gamma_1 = \beta_{1,2} - \alpha_1 \text{ für den Phasenwinkel zwischen } u_{1,2} \text{ und } i_2, \qquad (14)$$

$$\gamma_2 = \beta_{2,3} - \alpha_2 \text{ für den Phasenwinkel zwischen } u_{2,3} \text{ und } i_3 \text{ und} \qquad (15)$$

$$\gamma_3 = \beta_{3,1} - \alpha_3 \text{ für den Phasenwinkel zwischen } u_{3,1} \text{ und } i_1. \qquad (16)$$

Die Winkel $\gamma_1$, $\gamma_2$, $\gamma_3$ lassen sich auch für jede andere, nicht ohmsche oder nicht rein ohmsche Last berechnen, wenn der Phasenverschiebungswinkel zwischen den Lastströme $i_{1,2}$, $i_{2,3}$, $i_{3,1}$ und den verketteten Spannungen $u_{1,2}$, $u_{2,3}$, $u_{3,1}$, d.h. den Lastspannungen bekannt sind. Diese Phasenverschiebungswinkel zwischen den Lastströmen und Lastspannungen sind dann in den Gleichungen (14) bis (15) zu berücksichtigen. So kann man die Winkel $\gamma_1$, $\gamma_2$, $\gamma_3$ z.B. auch für bekannte ohmsch-induktive Lasten berechnen oder für unbekannte ohmsch-induktive Lasten berechnen, wenn der Phasenverschiebungswinkel zwischen den Lastströme $i_{1,2}$, $i_{2,3}$, $i_{3,1}$ und den verketteten Spannungen $u_{1,2}$, $u_{2,3}$, $u_{3,1}$ bekannt ist.

Weiter lassen sich dann die Phasenverschiebungswinkel $\psi_1$, $\psi_2$, $\psi_3$ zwischen den Lastströmen $I_{1,2}$, $I_{2,3}$, $I_{3,1}$ bzw. zwischen den verketteten Spannungen $u_{1,2}$, $u_{2,3}$, $u_{3,1}$ berechnen gemäß:

$$\psi_1 = 180° - \gamma_1 - \alpha_2, \qquad (17)$$

$$\psi_2 = 180° - \gamma_2 - \alpha_3 \text{ bzw} \qquad (18)$$

$$\psi_3 = 180° - \gamma_3 - \alpha_1. \qquad (19)$$

Betrachtet man nun die Zeigerdiagramme aus Fig. 2 und 3 erneut und wendet den Sinussatz auf die durch die Zeiger der Außenleiterströme und die Lastströme aufgespannten Dreiecke an, ergibt sich:

$$I_{1,2} = \frac{I_2 \cdot \sin \alpha_2}{\sin \psi_1}, \qquad (20)$$

$$I_{2,3} = \frac{I_3 \cdot \sin \alpha_3}{\sin \psi_2} \text{ und} \qquad (21)$$

$$I_{3,1} = \frac{I_1 \cdot \sin \alpha_1}{\sin \psi_3}. \qquad (22)$$

Aus den gemessenen Effektivwerten $U_{1,2}$, $U_{2,3}$, $U_{3,1}$ der verketteten Spannungen, die in der Dreiecksschaltung zugleich auch Lastspannungen sind, die über den Lasten R1, R2, R3 abfallen, und den gemäß den Gleichungen (20), (21), (22) berechneten Effektivwerten der Lastströme $I_{1,2}$, $I_{2,3}$, $I_{3,1}$ berechnet sich die Wirkleistung an den Lasten R1, R2, R3 durch Multiplikation

$$P_1 = I_{1,2} \cdot U_{1,2}, \qquad (23)$$

$$P_2 = I_{2,3} \cdot U_{2,3} \text{ und} \qquad (24)$$

$$P_3 = I_{3,1} \cdot U_{3,1}. \qquad (25)$$

Durch Summierung der Leistungen der einzelnen Lasten R1, R2, R3 ergibt sich dann die Gesamtleistung der Dreiecksschaltung.

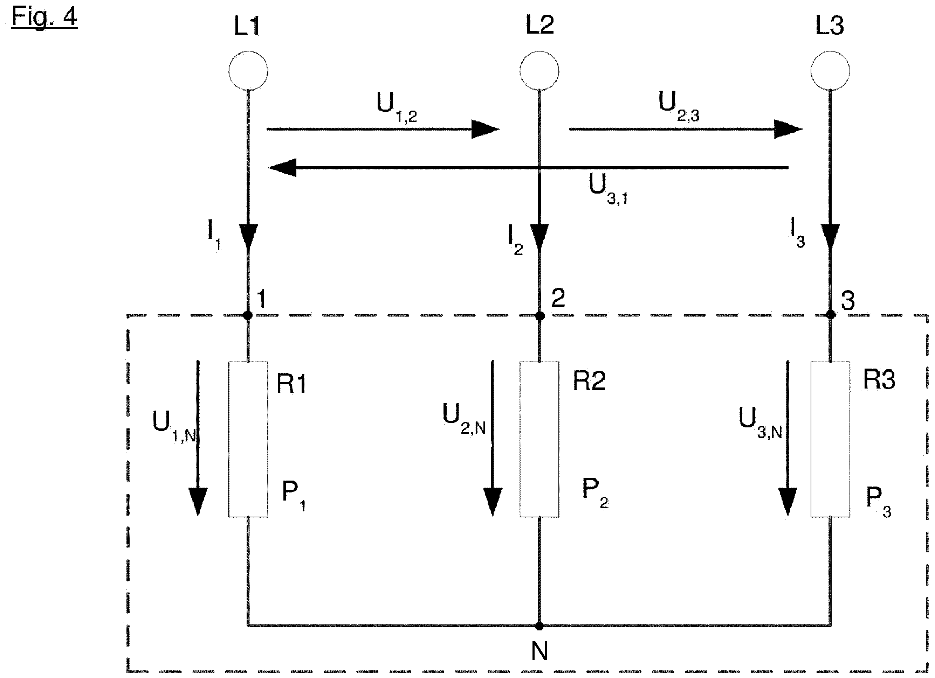

Die Sternschaltung gemäß Fig. 4 hat drei Lasten R1, R2, R3 die im Stern geschaltet sind. Auch die Lasten R1, R2, R3 werden über drei Außenleiter L1, L2, L3 einer Dreiphasenwechselstromversorgung mit elektrischer Energie versorgt. In den Außenleitern L1, L2, L3 fließen, durch eine Messeinrichtung (nicht dargestellt) erfasst, Außenleiterströme mit Effektivwerten $I_1$, $I_2$, $I_3$, die auch durch die Lasten R1, R2, R3 fließen und somit die Lastströme sind. Zwischen den Außenleitern L1, L2, L3 liegen verkettete Spannungen mit Effektivwerten $U_{1,2}$, $U_{2,3}$, $U_{3,1}$ an. Auch die verketteten Spannungen können durch die Messeinrichtung erfasst werden. Die Effektivwerte $I_1$, $I_2$, $I_3$ der Außenleiterströme und die Effektivwerte $U_{1,2}$, $U_{2,3}$, $U_{3,1}$ der verketteten Spannungen können gemäß Gleichung (2) oder (3) aus gemessenen Augenblickswerten berechnet werden.

Über den Lasten R1, R2, R3 fallen Lastspannungen $U_{1,N}$, $U_{2,N}$, $U_{3,N}$ ab, die nicht gemessen werden, die aber durch die Erfindung berechnet werden können. Ebenso wenig werden die Leistungen der Lasten R1, R2, R3 gemessen. Die Leistungen können aber berechnet werden, wenn die Lastspannungen $U_{1,N}$, $U_{2,N}$, $U_{3,N}$ durch Berechnung bekannt sind. Sind die Leistungen der Lasten R1, R2, R3 bekannt, kann die Gesamtleistung aller Lasten R1, R2, R3 berechnet werden.

Es wird nun davon ausgegangen, dass durch Messung und Berechnung die Effektivwerte $I_1$, $I_2$, $I_3$ der Außenleiterströme und die Effektivwerte $U_{1,2}$, $U_{2,3}$, $U_{3,1}$ der verketteten Spannungen bekannt sind.

Ferner wurden mittels der Effektivwerte $H_p$ der Hilfsgrößen die Phasenverschiebungswinkel $\alpha_p$ zwischen den verketteten Spannungen $u_{pp+1}$ und den Außenleiterströmen $i_p$ berechnet (Gleichungen (5) und (6)).

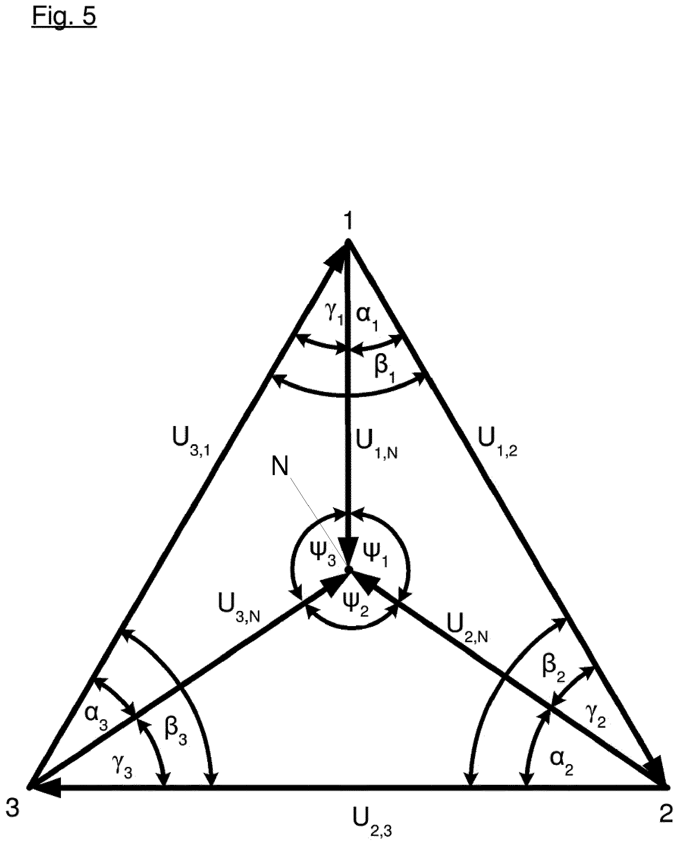

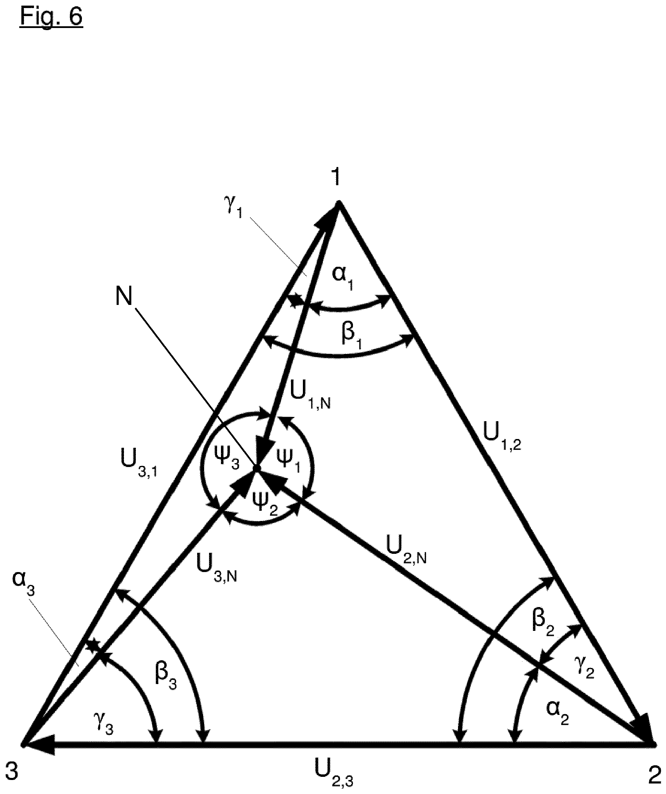

Betrachtet man nun das Zeigerdiagramm aus Fig. 5 oder aus Fig. 6 und wendet den Kosinussatz auf das durch die Zeiger der Außenleiterströme aufgespannte Dreieck an, ergibt sich:

$$U_{2,3}{}^2 = U_{3,1}{}^2 + U_{1,2}{}^2 - 2 \cdot U_{3,1} \cdot U_{1,2} \cdot \cos\beta_1, \qquad (26)$$

$$U_{3,1}{}^2 = U_{1,2}{}^2 + U_{2,3}{}^2 - 2 \cdot U_{1,2} \cdot U_{2,3} \cdot \cos\beta_2, \qquad (27)$$

$$U_{1,2}{}^2 = U_{2,3}{}^2 + U_{3,1}{}^2 - 2 \cdot U_{2,3} \cdot U_{3,1} \cdot \cos\beta_3, \qquad (28)$$

wobei $\beta_1$, $\beta_2$, $\beta_3$ Phasenverschiebungswinkel zwischen zwei verketteten Spannungen $u_{1,2}$, $u_{2,3}$, $u_{3,1}$ bezeichnen.

Löst man diese Gleichungen nach den Phasenverschiebungswinkeln $\beta_1$, $\beta_2$, $\beta_3$ auf, ergibt sich:

$$\beta_1 = \cos^{-1}\frac{U_{3,1}{}^2 + U_{1,2}{}^2 - U_{2,3}{}^2}{2 \cdot U_{3,1} \cdot U_{1,2}}, \qquad (29)$$

$$\beta_2 = \cos^{-1}\frac{U_{1,2}{}^2 + U_{2,3}{}^2 - U_{3,1}{}^2}{2 \cdot U_{1,2} \cdot U_{2,3}} \quad \text{und} \qquad (30)$$

$$\beta_3 = \cos^{-1}\frac{U_{2,3}{}^2 + U_{3,1}{}^2 - U_{1,2}{}^2}{2 \cdot U_{2,3} \cdot U_{3,1}} \qquad (31)$$

Sind die Phasenverschiebungswinkel $\alpha_1$, $\alpha_2$, $\alpha_3$ zwischen den verketteten Spannungen $u_{1,2}$, $u_{2,3}$, $u_{3,1}$ und den Außenleiterströmen $i_p$ (siehe Gleichungen (5) und (6)) und die Phasenverschiebungswinkel $\beta_1$, $\beta_2$, $\beta_3$ bekannt, können die Phasenverschiebungswinkel $\gamma_1$, $\gamma_2$, $\gamma_3$ zwischen den Außenleiterströmen bzw. Lastströmen $i_1$, $i_2$, $i_3$ und den verketteten Spannungen $u_{1,2}$, $u_{2,3}$, $u_{3,1}$ berechnet werden. Das ist einfach möglich, wenn die Lasten R1, R2, R3 beliebige ohmsche Lasten sind und die Lastströme $i_1$, $i_2$, $i_3$ deshalb in Phase mit den Lastspannungen $U_{1,N}$, $U_{2,N}$, $U_{3,N}$ sind. Dies vorausgesetzt ergeben sich die Phasenverschiebungswinkel $\gamma_1$, $\gamma_2$, $\gamma_3$ zwischen den verketteten Spannungen $u_{1,2}$, $u_{2,3}$, $u_{3,1}$ und den Außenleiterströmen $i_2$, $i_3$, $i_1$ zu

$$\gamma_1 = \beta_1 - \alpha_1 \text{ für den Phasenwinkel zwischen } u_{3,1} \text{ und } i_1, \qquad (32)$$

$$\gamma_2 = \beta_2 - \alpha_2 \text{ für den Phasenwinkel zwischen } u_{1,2} \text{ und } i_2 \text{ und} \qquad (33)$$

$$\gamma_3 = \beta_3 - \alpha_3 \text{ für den Phasenwinkel zwischen } u_{2,3} \text{ und } i_3. \qquad (34)$$

Die Winkel $\gamma_1$, $\gamma_2$, $\gamma_3$ lassen sich auch für jede andere, nicht ohmsche oder nicht rein ohmsche Last berechnen, wenn die Phasenverschiebungswinkel zwischen den Lastströme $i_1$, $i_2$, $i_3$ und den Lastspannungen $U_{1,N}$, $U_{2,N}$, $U_{3,N}$ bekannt sind. Diese Winkel müssen dann in den Gleichungen (32) bis (34) berücksichtigt werden. So kann man die Winkel $\gamma_1$, $\gamma_2$, $\gamma_3$ z.B. auch für bekannte ohmsch-induktive Lasten berechnen oder für unbekannte ohmsch-induktive Lasten berechnen, wenn der Phasenverschiebungswinkel zwischen den Lastströme $i_1$, $i_2$, $i_3$ und den Lastspannungen $U_{1,N}$, $U_{2,N}$, $U_{3,N}$ bekannt ist.

Weiter lassen sich dann die Phasenverschiebungswinkel $\psi_1$, $\psi_2$, $\psi_3$ zwischen den Lastspannungen $U_{1,N}$, $U_{2,N}$, $U_{3,N}$ bzw. zwischen den Außenleiterströmen/Lastströmen $i_1$, $i_2$, $i_3$ berechnen gemäß:

$$\psi_1 = 180° - \alpha_1 - \gamma_2, \qquad (35)$$

$$\psi_2 = 180° - \alpha_2 - \gamma_3 \text{ bzw} \qquad (36)$$

$$\psi_3 = 180° - \alpha_3 - \gamma_1 \qquad (37)$$

Betrachtet man nun die Zeigerdiagramme aus Fig. 5 und 6 erneut und wendet den Sinussatz auf das durch die Zeiger der verketteten Spannungen und der Lastspannungen aufgespannten Dreiecke an, ergibt sich:

$$U_{1,N} = \frac{U_{1,2} \cdot \sin\gamma_2}{\sin\psi_1}, \qquad (38)$$

$$U_{2,N} = \frac{U_{2,3} \cdot \sin\gamma_3}{\sin\psi_2} \text{ und} \qquad (39)$$

$$U_{3,N} = \frac{U_{3,1} \cdot \sin\gamma_1}{\sin\psi_3}. \qquad (40)$$

Aus den gemessenen Effektivwerten $I_1$, $I_2$, $I_3$ der Außenleiterströme, die in der Sternschaltung zugleich auch Lastströme sind, die durch die Lasten R1, R2, R3 fließen, und den gemäß den Gleichungen (20), (21), (22) berechneten Effektivwerten der Lastspannungen $U_{1,N}$, $U_{2,N}$, $U_{3,N}$ berechnet sich die Wirkleistung an den Lasten R1, R2, R3 durch Multiplikation

$$P_1 = I_1 \cdot U_{1,N}, \qquad (41)$$

$$P_2 = I_2 \cdot U_{2,N} \text{ und} \qquad (42)$$

$$P_3 = I_3 \cdot U_{3,N}. \qquad (45)$$

Durch Summierung der Leistungen der einzelnen Lasten R1, R2, R3 ergibt sich dann die Gesamtleistung der Sternschaltung.

Durch die anhand der Figuren gemachten Ausführungen zur Dreieckschaltung und Sternschaltung im Dreiphasenwechselstromsystem wird die Erfindung nicht auf die Anwendung der Erfindung in Dreiphasenwechselstromsystem beschränkt. Die den Ausführungen zugrunde liegenden Überlegungen, insbesondere die Anwendung des Kosinussatzes (Gleichungen (8) bis (13) bzw. (26) bis (31)) und des Sinussatzes (Gleichungen (20) bis (22) bzw. (38) bis (40)) könnten zwar einen Fachmann zu dem Schluss verleiten, die Erfindung sei nur auf Dreieckschaltungen und Sternschaltungen im Dreiphasenwechselstromsystem beschränkt. Es hat sich aber gezeigt, dass die Erfindung auch auf Mehrphasenwechselstromsysteme mit mehr als drei Phasen anwendbar ist. Dieses ist möglich, da bei einer Sternschaltung die verketteten Spannungen und die Phasenverschiebungswinkel zwischen den verketteten Spannungen und bei einer Polygonschaltung die Außenleiterspannungen und die Phasenverschiebungswinkel zwischen Außenleiterspannungen bekannt sind oder ermittelt werden können.

Unter dieser Voraussetzung kann in den Zeigerdiagrammen immer ein Dreieck aus zwei verketteten Spannungen bzw. Außenleiterströmen als zwei kürzeren Dreieckseiten und dem Summenvektor der beiden zwei verketteten Spannungen bzw. Außenleiterströmen als längerer Seite des Dreiecks identifiziert werden. Bei einer Sternschaltung ist dieses Dreieck bei einem Mehrphasensystem mit aufgeprägter verketteter Spannung ein gleichschenkliges Dreieck. Das identifizierte Dreieck schafft die Grundlage für die Anwendung des Kosinussatzes entsprechend der Gleichungen (8) bis (13) bzw. (26) bis (31). Die Berechnung der weiteren Größen kann dann entsprechend der Gleichungen (14) bis (25) bzw. (32) bis (45) erfolgen.

Das erfindungsgemäße Verfahren ist sowohl bei sinusförmigen Strömen und Spannungen als auch bei nicht sinusförmigen Strömen und Spannungen anwendbar, da bei den Überlegungen keine Voraussetzungen zur Strom- oder Spannungsform getroffen wurden.

**Patentansprüche**

1. Verfahren zur Ermittlung elektrischer Größen an Lasten (R1, R2, R3) in

   - einer Polygonschaltung oder
   - einer Sternschaltung mit Sternpunkt aber ohne Neutralleiter

   eines Mehrphasenwechselstromsystems mit $P$ Phasen, wobei die Polygonschaltung bzw. die Sternschaltung aufgebaut ist und wobei mittels einer Messeinrichtung durch synchrone Abtastung von

   - Augenblickswerten $\underline{u}_{p,p+1}$ und $\underline{u}_{P,1}$ von verketteten Spannungen $u_{p,p+1}(t)$ und $u_{P,1}(t)$ und
   - Augenblickswerten $\underline{i}_p$ von Außenleiterströmen $i_p(t)$,

   mit $3 \leq P,\ 1 \leq p \leq P$ und $p$ als Element der natürlichen Zahlen, gemessen werden, **dadurch gekennzeichnet, dass** für

   - die Polygonschaltung die Effektivwerte der Lastströme $I_{1,2},...,I_{P-1,P},I_{P,1}$ bzw.
   - die Sternschaltung die Effektivwerte der Lastspannungen $U_{1,N},...,U_{P,N}$

   mit Hilfe von Produkten $\underline{h}_p = \underline{u}_{p,p+1} \cdot \underline{i}_p,\ ...,\ \underline{h}_P = \underline{u}_{P,1} \cdot \underline{i}_P$, der Augenblickswerte der verkettete Spannungen $\underline{u}_{p,p+1}$ und $\underline{u}_{P,1}$ und der Augenblickswerte Außenleiterströme $\underline{i}_p$ berechnet werden.

2. Verfahren nach Anspruch 1, **dadurch gekennzeichnet, dass** aus den Augenblickswerten $\underline{u}_{p,p+1}$ und $\underline{u}_{P,1}$ der verketteten Spannungen Effektivwerte $U_{p,p+1}$ und $U_{P,1}$ der verketteten Spannungen berechnet werden.

3. Verfahren nach Anspruch 1 oder 2, **dadurch gekennzeichnet, dass** aus den Augenblickswerten $\underline{i}_p$ der Außenleiterströme Effektivwerte $I_p$ der Außenleiterströme berechnet werden.

4. Verfahren nach Anspruch 2 und 3, **dadurch gekennzeichnet, dass** aus den Produkten $\underline{h}_p = \underline{u}_{p,p+1} \cdot \underline{i}_p,\ ...,\ \underline{h}_P = \underline{u}_{P,1} \cdot \underline{i}_P$, nachfolgend als Augenblickswerte $\underline{h}_p$ von Hilfsgrößen bezeichnet, Effektivwerte $H_p$ der Hilfsgrößen berechnet werden.

5. Verfahren nach Anspruch 4, **dadurch gekennzeichnet, dass** aus den Effektivwerten $H_p$ der Hilfsgrößen, den Effektivwerten $U_{p,p+1}$ und $U_{P,1}$ der verketteten Spannung und den Effektivwerten $I_p$ der Außenleiterströme Phasenverschiebungswinkel $\alpha_p$ zwischen den verketteten Spannungen $u_{p,p+1}(t)$ und $u_{P,1}(t)$ und den Außenleiterströmen $i_p(t)$ berechnet werden gemäß

$$\alpha_p = \cos^{-1} \frac{H_p}{I_p \cdot U_{p,p+1}} \quad \text{für} \quad 1 \le p < P$$

bzw.

$$\alpha_P = \cos^{-1} \frac{H_P}{I_P \cdot U_{P,1}} \quad \text{für} \quad p = P.$$

6. Verfahren nach Anspruch 3 oder 4, **dadurch gekennzeichnet, dass** bei einer Dreiecksschaltung als Polygonschaltung mit $P = 3$ und einem Aufbau der Dreiecksschaltung die Phasenverschiebungswinkel $\beta_{1,2}$, $\beta_{2,3}$, $\beta_{3,1}$ zwischen zwei Außenleiterströmen $i_1$, $i_2$, $i_3$ berechnet werden gemäß

$$\beta_{1,2} = \cos^{-1} \frac{I_1^2 + I_2^2 - I_3^2}{2 \cdot I_1 \cdot I_2},$$

$$\beta_{2,3} = \cos^{-1} \frac{I_2^2 + I_3^2 - I_1^2}{2 \cdot I_2 \cdot I_3}$$

und

$$\beta_{3,1} = \cos^{-1} \frac{I_3^2 + I_1^2 - I_2^2}{2 \cdot I_3 \cdot I_1}.$$

7. Verfahren nach Anspruch 6, **dadurch gekennzeichnet, dass**, wenn die Lasten ohmsche Lasten sind, Phasenverschiebungswinkel $\gamma_p$ zwischen den verketteten Spannungen $u_{p,p+1}$ und den Außenleiterströmen $i_{p+1}$ berechnet werden gemäß

$$\gamma_p = \beta_{p,p+1} - \alpha_p \quad \text{für} \quad 1 \le p \le 2$$

bzw.

$$\gamma_3 = \beta_{3,1} - \alpha_3 \quad \text{für} \quad p = 3.$$

8. Verfahren nach Anspruch 7, **dadurch gekennzeichnet, dass** Phasenverschiebungswinkel $\psi_p$ zwischen den verketteten Spannungen $u_{1,2}$, $u_{2,3}$, $u_{3,1}$ berechnet werden gemäß

$$\psi_1 = 180° - \gamma_1 - \alpha_2,$$

$$\psi_2 = 180° - \gamma_2 - \alpha_3$$

bzw

$$\psi_3 = 180° - \gamma_3 - \alpha_1$$

9. Verfahren nach Anspruch 8, **dadurch gekennzeichnet, dass** die Effektivwerte der Lastströme $I_{1,2}$, $I_{2,3}$, $I_{3,1}$ in der Dreiecksschaltung berechnet werden gemäß

$$I_{1,2} = \frac{I_2 \cdot \sin \alpha_2}{\sin \psi_1},$$

$$I_{2,3} = \frac{I_3 \cdot \sin \alpha_3}{\sin \psi_2}$$

und

$$I_{3,1} = \frac{I_1 \cdot \sin \alpha_1}{\sin \psi_3}.$$

**10.** Verfahren nach Anspruch 2 oder 4, **dadurch gekennzeichnet, dass** bei einer Sternschaltung mit $P$ = 3 Phasenverschiebungswinkel $\beta_1$, $\beta_2$, $\beta_3$ zwischen zwei verketteten Spannungen $u_{1,2}$, $u_{2,3}$, $u_{3,1}$ berechnet werden gemäß

$$\beta_1 = \cos^{-1} \frac{U_{3,1}{}^2 + U_{1,2}{}^2 - U_{2,3}{}^2}{2 \cdot U_{3,1} \cdot U_{1,2}},$$

$$\beta_2 = \cos^{-1} \frac{U_{1,2}{}^2 + U_{2,3}{}^2 - U_{3,1}{}^2}{2 \cdot U_{1,2} \cdot U_{2,3}}$$

und

$$\beta_3 = \cos^{-1} \frac{U_{2,3}{}^2 + U_{3,1}{}^2 - U_{1,2}{}^2}{2 \cdot U_{2,3} \cdot U_{3,1}}.$$

**11.** Verfahren nach Anspruch 10, **dadurch gekennzeichnet, dass**, wenn die Lasten ohmsche Lasten sind, Phasenverschiebungswinkel $\gamma_p$ zwischen den verketteten Spannungen $u_{p,p+1}$ und den Außenleiterströmen $i_{p+1}$ berechnet werden gemäß

$$\gamma_p = \beta_p - \alpha_p \quad \text{für} \quad 1 \le p \le 3.$$

**12.** Verfahren nach Anspruch 11, **dadurch gekennzeichnet, dass** Phasenverschiebungswinkel $\psi_p$ zwischen den Lastströmen $i_1$, $i_2$, $i_3$ berechnet werden gemäß

$$\psi_1 = 180° - \alpha_1 - \gamma_2,$$

$$\psi_2 = 180° - \alpha_2 - \gamma_3$$

bzw.

$$\psi_3 = 180° - \alpha_3 - \gamma_1$$

**13.** Verfahren nach Anspruch 12, **dadurch gekennzeichnet, dass** die Effektivwerte der Lastspannungen $U_{1,N}$, $U_{2,N}$, $U_{3,N}$ in der Sternschaltung berechnet werden gemäß

$$U_{1,N} = \frac{U_{1,2} \cdot \sin\gamma_2}{\sin\psi_1},$$

$$U_{2,N} = \frac{U_{2,3} \cdot \sin\gamma_3}{\sin\psi_2}$$

und

$$U_{3,N} = \frac{U_{3,1} \cdot \sin\gamma_1}{\sin\psi_3}.$$

**14.** Verfahren nach Anspruch 9 oder 13, **dadurch gekennzeichnet, dass** durch Multiplikation von Effektivwerten der Lastspannungen und Effektivwerten der Lastströme die Leistungen der Lasten berechnet werden.

**15.** Mess- und Berechnungsvorrichtung mit einer Messeinrichtung zur synchronen Abtastung von Augenblickswerten

- von verketteten Spannungen $u_{p,p+1}$ und
- von Außenleiterströmen $i_p$,

eines Dreiphasenwechselstromsystems,
**dadurch gekennzeichnet, dass**
die Mess- und Berechnungsvorrichtung eine Berechnungseinrichtung zur Berechnung

- einer Hilfsgröße nach dem Verfahren nach Anspruch 1,
- eines Effektivwertes nach dem Verfahren nach Anspruch 2,
- eines Effektivwertes nach dem Verfahren nach Anspruch 3,
- eines Effektivwertes der Hilfsgröße nach dem Verfahren nach Anspruch 4,
- eines Phasenverschiebungswinkels zwischen den verketteten Spannungen und den Außenleiterströmen nach Anspruch 5,
- bei einer Dreiecksschaltung, eines Phasenverschiebungswinkels zwischen zwei Außenleiterströmen nach Anspruch 6,
- bei einer Dreiecksschaltung, eines Phasenverschiebungswinkels zwischen den verketteten Spannungen und den Außenleiterströmen nach Anspruch 7,
- bei einer Dreiecksschaltung, eines Phasenverschiebungswinkels zwischen den verketteten Spannungen nach Anspruch 8,
- bei einer Dreiecksschaltung, eines Effektivwertes der Lastströme nach Anspruch 9,
- bei einer Sternschaltung, eines Phasenverschiebungswinkels zwischen zwei verketteten Spannungen nach Anspruch 10,
- bei einer Sternschaltung, eines Phasenverschiebungswinkels zwischen den verketteten Spannungen und den Außenleiterströmen nach Anspruch 11,
- bei einer Sternschaltung, eines Effektivwertes der Lastspannungen nach Anspruch 13,
- bei einer Sternschaltung oder einer Dreiecksschaltung, einer Leistung nach Anspruch 14

aufweist.

**Claims**

**1.** Method for determining electrical quantities on loads (R1, R2, R3) in

- a polygon circuit or
- a star circuit with star point but without neutral conductor of a polyphase alternating current system with P phases, wherein the polygon circuit or the star circuit is set up and wherein by means of a measuring device by synchronous sampling of
- instantaneous $\underline{u}_{p,p+1}$ and $\underline{u}_{P,1}$ line-to-line voltages $u_{p,p+1}(t)$ and $u_{P,1}(t)$

- instantaneous values $\underline{i}_p$ of outer conductor currents $i_p(t)$, with $3 \leq P$, $1 \leq p \leq P$ and $p$ being measured as an element of natural numbers,

**characterised in that**

- for the polygon circuit the effective values of the load currents $I_{1,2}$, ..., $I_{P-1,P}$, $I_{P,1}$ and
- for the star circuit, the effective values of the load voltages $U_{1,N}$,..., $U_{P,N}$ respectively are calculated with the help of products $\underline{h}_p = \underline{u}_{p,p+1} \cdot \underline{i}_p$, ..., $\underline{h}_P = \underline{u}_{P,1} \cdot \underline{i}_P$, of the instantaneous values of the line-to-line voltages $\underline{u}_{p,p+1}$ and $\underline{u}_{P,1}$ and of the instantaneous values of outer conductor currents $\underline{i}_p$.

2. Method according to claim 1, **characterised in that**, from the instantaneous values $U_{p,p+1}$ and $U_{P,1}$ of the line-to-line voltages, effective values $\underline{u}_{p,p+1}$ and $\underline{u}_{P,1}$ of the line-to-line voltages are calculated.

3. Method according to claim 1 or 2, **characterised in that** from the instantaneous values $i_p$ of the outer conductor currents, effective values $\underline{I}_p$ of the outer conductor currents are calculated.

4. Method according to claim 2 and 3, **characterised in that** from the products $\underline{h}_p = \underline{u}_{p,p+1} \cdot \underline{i}_p$, ..., $\underline{h}_p = \underline{u}_{P,1} \cdot \underline{i}_P$, below referred to as instantaneous values $\underline{h}_P$ of auxiliary quantities, effective values $H_p$ of the auxiliary quantities are calculated.

5. Method according to claim 4, **characterised in that** from the effective values $H_p$ of the auxiliary quantities, the effective values $U_{p,p+1}$ and $U_{P,1}$ the line-to-line voltage and the effective values $I_p$ of the outer conductor currents, phase shift angle $\alpha_p$ between the line-to-line voltages $u_{p,p+1}(t)$ and $u_{P,1}(t)$ and the outer conductor currents $i_p(t)$ are

$$\alpha_p = \cos^{-1} \frac{H_p}{I_p \cdot U_{p,p+1}}$$

calculated according to                              for $1 \leq p < P$ and/or

$$\alpha_p = \cos^{-1} \frac{H_p}{I_p \cdot U_{P,1}} \quad \text{for } p = P.$$

6. Method according to claim 3 or 4, **characterised in that** in a triangular circuit as a polygon circuit with $P=3$ and a setup of the triangular circuit, the phase shift angles $\beta_{1,2}$, $\beta_{2,3}$, $\beta_{3,1}$ between two outer conductor currents $i_1$, $i_2$, $i_3$ are calculated according to

$$\beta_{1,2} = \cos^{-1} \frac{I_1^2 + I_2^2 - I_3^2}{2 \cdot I_1 \cdot I_2},$$

$$\beta_{2,3} = \cos^{-1} \frac{I_2^2 + I_3^2 - I_1^2}{2 \cdot I_2 \cdot I_3}$$

and

$$\beta_{3,1} = \cos^{-1} \frac{I_3^2 + I_1^2 - I_2^2}{2 \cdot I_3 \cdot I_1}.$$

7. Method according to claim 6, **characterised in that** when the loads are resistive loads, phase shift angles $\gamma_P$ between the line-to-line voltages $\underline{u}_{p,p+1}$ and the outer conductor currents $i_{p+1}$ are calculated according to

$$\gamma_p = \beta_{p,p+1} - \alpha_p$$
$$\text{for } 1 \leq p \leq 2$$

and

$$\gamma_3 = \beta_{3,1} - \alpha_3 \quad \text{for } p = 3$$

respectively.

8. Method according to claim 7, **characterised in that** phase shift angles $\psi_P$ between the line-to-line voltages $u_{1,2}$, $u_{2,3}$, $u_{3,1}$ are calculated according to

$$\psi_1 = 180° - \gamma_1 - \alpha_2,$$

$$\psi_2 = 180° - \gamma_2 - \alpha_3$$

and

$$\psi_3 = 180° - \gamma_3 - \alpha_1$$

respectively.

9. Method according to claim 8, **characterised in that** the effective values of the load currents $I_{1,2}$, $I_{2,3}$, $I_{3,1}$ in the triangular circuit are calculated according to

$$I_{1,2} = \frac{I_2 \cdot \sin \alpha_2}{\sin \psi_1},$$

$$I_{2,3} = \frac{I_3 \cdot \sin \alpha_3}{\sin \psi_2}$$

and

$$I_{3,1} = \frac{I_1 \cdot \sin \alpha_1}{\sin \psi_3}.$$

10. Method according to claim 2 or 4, **characterised in that** in a star circuit with $P = 3$ phase shift angles $\beta_1$, $\beta_2$, $\beta_3$ between two line-to-line voltages $u_{1,2}$, $u_{2,3}$, $u_{3,1}$ are calculated according to

$$\beta_1 = \cos^{-1} \frac{U_{3,1}^2 + U_{1,2}^2 - U_{2,3}^2}{2 \cdot U_{3,1} \cdot U_{1,2}},$$

$$\beta_2 = \cos^{-1} \frac{U_{1,2}^2 + U_{2,3}^2 - U_{3,1}^2}{2 \cdot U_{1,2} \cdot U_{2,3}}$$

and

$$\beta_3 = \cos^{-1} \frac{U_{2,3}^2 + U_{3,1}^2 - U_{1,2}^2}{2 \cdot U_{2,3} \cdot U_{3,1}}.$$

11. Method according to claim 10, **characterised in that**, when the loads are resistive loads, phase shift angles $\gamma_P$ between the line-to-line voltages $u_{p,p+1}$ and the outer conductor currents $i_{p+1}$ are calculated according to

$$\gamma_p = \beta_p - \alpha_p \quad \text{for } 1 \le p \le 3.$$

12. Method according to claim 11, **characterised in that** phase shift angles $\psi_P$ between the load currents $i_1$, $i_2$, $i_3$ are calculated according to

$$\psi_1 = 180° - \alpha_1 - \gamma_2 ,$$

$$\psi_2 = 180° - \alpha_2 - \gamma_3$$

and

$$\psi_3 = 180° - \alpha_3 - \gamma_1$$

respectively.

13. Method according to claim 12, **characterised in that** the effective values of the load voltages $U_{1,N}$, $U_{2,N}$, $U_{3,N}$ in the star circuit are calculated in accordance with

$$U_{1,N} = \frac{U_{1,2} \cdot \sin \gamma_2}{\sin \psi_1} ,$$

$$U_{2,N} = \frac{U_{2,3} \cdot \sin \gamma_3}{\sin \psi_2}$$

and

$$U_{3,N} = \frac{U_{3,1} \cdot \sin \gamma_1}{\sin \psi_3} .$$

14. Method according to claim 9 or 13, **characterised in that** the power of the loads is calculated by multiplying the effective values of the load voltages and effective values of the load currents.

15. Measuring and calculating apparatus with a measuring device for the synchronous sampling of instantaneous values

- of line-to-line voltages $u_{p,p+1}$ and
- of outer conductor currents $i_p$, of a three-phase rotary current system, **characterised in that** the measuring and calculating apparatus has a calculation device for the calculation
- of an auxiliary variable according to the method of claim 1,
- of an effective value according to the method of claim 2,
- of an effective value according to the method of claim 3,
- of an effective value of the auxiliary variable according to the method of claim 4,
- of a phase shift angle between the line-to-line voltages and the outer conductor currents according to claim 5,
- in a triangular circuit, of a phase shift angle between two outer conductor currents according to claim 6,
- in a triangular circuit, of a phase shift angle between the line-to-line voltages and the outer conductor currents according to claim 7,
- in a triangular circuit, of a phase shift angle between the line-to-line voltages according to claim 8,
- in a triangular circuit, an effective value of the load currents according to claim 9,
- in a star circuit, of a phase shift angle between two line-to-line voltages according to claim 10,
- in a star circuit, of a phase shift angle between the line-to-line voltages and the outer conductor currents according to claim 11,
- in a star circuit, of an effective value of the load voltages according to claim 13,

- in a star circuit or of a triangular circuit, of a power according to claim 14.

**Revendications**

1. Procédé de détermination de grandeurs électriques au niveau de charges (R1, R2, R3) dans

    - un circuit polygonal ou
    - un circuit en étoile avec point étoile mais sans conducteur neutre

d'un système de courant alternatif polyphasé avec P phases, dans lequel le circuit polygonal ou le circuit en étoile est construit et dans lequel au moyen d'un dispositif de mesure par balayage synchrone de

    - valeurs instantanées $\underline{u}_{p,p+1}$ et $\underline{u}_{P,1}$ de tensions composées $u_{p,p+1}(t)$ et $u_{P,1}(t)$ et
    - valeurs instantanées $\underline{i}_p$ de courants de conducteur externe $i_p(t)$,

avec $3 \leq P$, $1 \leq p \leq P$ et p comme élément des nombres naturels, sont mesurées **caractérisé en ce que** pour

    - le circuit polygonal, les valeurs efficaces des courants de charge $I_{1,2}$, ..., $I_{P-1,P}$, $I_{P,1}$ et respectivement
    - le circuit en étoile, les valeurs efficaces des tensions de charge $U_{1,N}$,..., $U_{P,N}$

à l'aide de produits $\underline{h}_p = \underline{u}_{p,p+1} \cdot \underline{i}_p$, ..., $\underline{h}_P = \underline{u}_{P,1} \cdot \underline{i}_P$, des valeurs instantanées des tensions composées $\underline{u}_{p,p+1}$ et $\underline{u}_{P,1}$ et des valeurs instantanées de courants de conducteur externe $\underline{i}_p$ sont calculées.

2. Procédé selon la revendication 1, **caractérisé en ce que** des valeurs efficaces $U_{p,p+1}$ et $U_{P,1}$ des tensions composées sont calculées à partir des valeurs instantanées $\underline{u}_{p,p+1}$ et $\underline{u}_{P,1}$ des tensions composées.

3. Procédé selon la revendication 1 ou 2, **caractérisé en ce que** des valeurs efficaces $I_p$ des courants de conducteur externe sont calculées à partir des valeurs instantanées $\underline{i}_p$ des courants de conducteur externe.

4. Procédé selon la revendication 2 ou 3, **caractérisé en ce que** des valeurs efficaces $H_p$ des grandeurs auxiliaires sont calculées à partir des produits $\underline{h}_p = \underline{u}_{p,p+1} \cdot \underline{i}_p$, ..., $\underline{h}_P = \underline{u}_{P,1} \cdot \underline{i}_P$, appelés ci-après valeurs instantanées $\underline{h}_p$ de grandeurs auxiliaires.

5. Procédé selon la revendication 4, **caractérisé en ce qu'**à partir des valeurs efficaces $H_p$ des grandeurs auxiliaires, des valeurs efficaces $U_{p,p+1}$ et $U_{P,1}$ de la tension composées et des valeurs efficaces $I_p$ des courants de conducteur externe, des angles de déphasage $\alpha_p$ entre les tensions composées $u_{p,p+1}(t)$ et $u_{P,1}(t)$ et les courants de conducteur externe $i_p(t)$ sont calculées conformément à

$$\alpha_p = \cos^{-1} \frac{H_p}{I_p \cdot U_{p,p+1}} \quad \text{pour } 1 \leq p < P$$

et respectivement

$$\alpha_p = \cos^{-1} \frac{H_P}{I_P \cdot U_{P,1}}$$

$$\text{pour } p = P.$$

6. Procédé selon la revendication 3 ou 4, **caractérisé en ce que** dans le cas d'un circuit triangulaire en tant que circuit polygonal avec P = 3 et d'une construction du circuit triangulaire, les angles de déphasage $\beta_{1,2}$, $\beta_{2,3}$, $\beta_{3,1}$ entre deux courants de conducteur externe $i_1$, $i_2$, $i_3$ sont calculés conformément à

$$\beta_{1,2} = \cos^{-1} \frac{I_1^2 + I_2^2 - I_3^2}{2 \cdot I_1 \cdot I_2},$$

$$\beta_{2,3} = \cos^{-1} \frac{I_2^2 + I_3^2 - I_1^2}{2 \cdot I_2 \cdot I_3}$$

et

$$\beta_{3,1} = \cos^{-1} \frac{I_3^2 + I_1^2 - I_2^2}{2 \cdot I_3 \cdot I_1}.$$

**7.** Procédé selon la revendication 6, **caractérisé en ce que** lorsque les charges sont des charges ohmiques, des angles de déphasage $\gamma_P$ entre les tensions composées $u_{p,p+1}$ et les courants de conducteur externe $i_{p+1}$ sont calculés conformément à

$$\gamma_p = \beta_{p,p+1} - \alpha_p \quad \text{pour } 1 \leq p \leq 2$$

et respectivement

$$\gamma_3 = \beta_{3,1} - \alpha_3 \quad \text{pour } p = 3.$$

**8.** Procédé selon la revendication 7, **caractérisé en ce que** des angles de déphasage $\psi_P$ entre les tensions composées $u_{1,2}$, $u_{2,3}$, $u_{3,1}$ sont calculés conformément à

$$\psi_1 = 180° - \gamma_1 - \alpha_2,$$

$$\psi_2 = 180° - \gamma_2 - \alpha_3$$

et respectivement

$$\psi_3 = 180° - \gamma_3 - \alpha_1.$$

**9.** Procédé selon la revendication 8, **caractérisé en ce que** les valeurs efficaces des courants de charge $I_{1,2}$, $I_{2,3}$, $I_{3,1}$, dans le circuit triangulaire sont calculées conformément à

$$I_{1,2} = \frac{I_2 \cdot \sin \alpha_2}{\sin \psi_1},$$

$$I_{2,3} = \frac{I_3 \cdot \sin \alpha_3}{\sin \psi_2}$$

et

$$I_{3,1} = \frac{I_1 \cdot \sin \alpha_1}{\sin \psi_3}.$$

**10.** Procédé selon la revendication 2 ou 4, **caractérisé en ce que** dans le cas d'un circuit en étoile avec P = 3 des

angles de déphasage $\beta_1$, $\beta_2$, $\beta_3$ entre deux tensions composées $u_{1,2}$, $u_{2,3}$, $u_{3,1}$ sont calculés conformément à

$$\beta_1 = \cos^{-1}\frac{U_{3,1}^2 + U_{1,2}^2 - U_{2,3}^2}{2 \cdot U_{3,1} \cdot U_{1,2}},$$

$$\beta_2 = \cos^{-1}\frac{U_{1,2}^2 + U_{2,3}^2 - U_{3,1}^2}{2 \cdot U_{1,2} \cdot U_{2,3}}$$

et

$$\beta_3 = \cos^{-1}\frac{U_{2,3}^2 + U_{3,1}^2 - U_{1,2}^2}{2 \cdot U_{2,3} \cdot U_{3,1}}.$$

**11.** Procédé selon la revendication 10, **caractérisé en ce que** lorsque les charges sont des charges ohmiques, des angles de déphasage $\gamma_P$ entre les tensions composées $u_{p,p+1}$ et les courants de conducteur externe $i_{p+1}$ sont calculés conformément à

$$\gamma_p = \beta_p - \alpha_p \quad \text{pour } 1 \leq p \leq 3.$$

**12.** Procédé selon la revendication 11, **caractérisé en ce que** des angles de déphasage $\psi_P$ entre les courants de charge $i_1$, $i_2$, $i_3$ sont calculés conformément à

$$\psi_1 = 180° - \alpha_1 - \gamma_2,$$

$$\psi_2 = 180° - \alpha_2 - \gamma_3$$

et respectivement

$$\psi_3 = 180° - \alpha_3 - \gamma_1$$

**13.** Procédé selon la revendication 12, **caractérisé en ce que** les valeurs efficaces des tensions de charge $U_{1,N}$, $U_{2,N}$, $U_{3,N}$ dans le circuit en étoile sont calculées conformément à

$$U_{1,N} = \frac{U_{1,2} \cdot \sin\gamma_2}{\sin\psi_1},$$

$$U_{2,N} = \frac{U_{2,3} \cdot \sin\gamma_3}{\sin\psi_2}$$

et

$$U_{3,N} = \frac{U_{3,1} \cdot \sin\gamma_1}{\sin\psi_3}.$$

**14.** Procédé selon la revendication 9 ou 13, **caractérisé en ce que** les puissances des charges sont calculées par multiplication de valeurs efficaces des tensions de charge et de valeurs efficaces des courants de charge.

15. Appareil de mesure et de calcul avec un dispositif de mesure pour le balayage synchrone de valeurs instantanées

   - de tensions composées $\underline{u}_{p,p+1}$ et
   - de courants de conducteur externe $i_p$,

d'un système de courant alternatif triphasé
**caractérisé en ce que**
l'appareil de mesure et de calcul présente un dispositif de calcul pour le calcul

   - d'une grandeur auxiliaire selon le procédé selon la revendication 1,
   - d'une valeur efficace selon le procédé selon la revendication 2,
   - d'une valeur efficace selon le procédé selon la revendication 3,
   - d'une valeur efficace de la grandeur auxiliaire selon le procédé selon la revendication 4,
   - d'un angle de déphasage entre les tensions composées et les courants de conducteur externe selon la revendication 5,
   - dans le cas d'un circuit triangulaire, d'un angle de déphasage entre les deux courants de conducteur externe selon la revendication 6,
   - dans le cas d'un circuit triangulaire, d'un angle de déphasage entre les tensions composées et les courants de conducteur externe selon la revendication 7,
   - dans le cas d'un circuit triangulaire, d'un angle de déphasage entre les tensions composées selon la revendication 8,
   - dans le cas d'un circuit triangulaire, d'une valeur efficace des courants de charge selon la revendication 9,
   - dans le cas d'un circuit en étoile, d'un angle de déphasage entre deux tensions composées selon la revendication 10,
   - dans le cas d'un circuit en étoile, d'un angle de déphasage entre les tensions composées et les courants de conducteur externe selon la revendication 11,
   - dans le cas d'un circuit en étoile, d'une valeur efficace des tensions de charge selon la revendication 13,
   - dans le cas d'un circuit en étoile ou d'un circuit triangulaire, d'une puissance selon la revendication 14.

Fig. 1

Fig. 2

Fig. 3

Fig. 4

## Fig. 5

## Fig. 6

**EP 2 843 427 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120259565 A1